# EUROPEAN PATENT APPLICATION

(11) **EP 1 548 943 A1**
(43) Date of publication of application: **29.06.2005**
(21) Application number: 03360133.7
(22) Date of filing: 28.11.2003
(51) Int. Cl.: H03K 19/0175, H03K 19/0185

(54) **ECL to CMOS converter**

(71) Applicant: ALCATEL, 75008 Paris (FR)
(72) Inventor: Ilchmann, Frank, 13158 Berlin (DE)
(74) Representative: Kohler Schmid Möbus

(57) **Abstract**

A Converter (1) for converting ECL input signals (ECL+, ECL-)delivered from an ECL circuit part operating at a first supply voltage (VccECL) into CMOS output signals (CMOS+, CMOS-) for a CMOS circuit part operating at a second, different operating voltage (VccCMOS), comprises an input stage (2) for decoupling and shifting the signal level of the ECL signals (ECL+, ECL-), a level shifter (3) connected to the input stage (2), and an output stage (6) having the CMOS signals (CMOS+, CMOS-) at its output, wherein the input stage (2) and the level shifter (3) are connected to the ECL operating voltage (VccECL) and the output stage (6) is connected to the CMOS operating voltage (VccCMOS). Such a converter allows signal conversion with low propagation delays.

## Description

### Background of the invention

The invention relates to a converter for converting ECL (emitter coupled logic) input signals delivered from an ECL circuit part operating at a first supply voltage into CMOS (complementary metal oxide semiconductor) output signals for a CMOS circuit part operating at a second, different operating voltage.

Logic converters are used to adjust different logic levels. The converter has the task of converting signals with the corresponding frequency. Such signals occur p. ex. between active components within a chip or between two chips. Theses components may be arranged close to one another or be spaced apart. For example, such components may be connected via a bus. The components may be integrated in network elements having a fair distance from one another.

Signal exchanging systems, in general telecommunications systems or networks, have to exchange (electrical) signals reliably and as quickly as possible. In order to achieve this, defined uniform transmission rates (frequencies) and defined amplitudes are used.

Differential ECL circuits are used for data transmission due to their fast data processing and advantageous signal properties. The differential aspect of these signals with low potential levels leads, p. ex., to a good signal-to-noise ratio.

From a technological point of view it is possible and desirable to convert ECL signal with low potential level into signals with higher potential level, p. ex. signals of CMOS circuits, without a significant loss in velocity, such that a converter can supply CMOS circuits with appropriate signals.

Conversion of ECL signals into CMOS signals is typically performed in three steps. An input stage receives and buffers, i.e. decouples, the ECL signals, which are supplied with a signal level swing of a few 100 mV with respect to the positive operating voltage of the ECL circuit part. A level shifter shifts the ECL signal level towards the CMOS threshold voltage and increases the signal level swing. An output stage forms a CMOS compatible output signal.

In the state of the art solutions are known for circuits comprising an ECL part and a CMOS part, both being connected to the same operating voltage. Hence, the converter is connected to the common operating voltage as well.

The trend for further miniaturization of semiconductor technologies leads to a decrease in allowable operating voltages for ECL and CMOS circuit parts. However, in order to fully benefit from the ECL and CMOS circuits, different operating voltages must be used for the ECL and CMOS parts. Bipolar ECL circuit parts typically operate in the range from 2.5 to 5.0 V. In contrast, the operating voltage of CMOS circuit parts, at present, is typically below 2.0 V, p.ex. 1.8 V.

This implies that at the interface between ECL and CMOS circuit parts not only the ECL signal level swing of a few hundred mV must be increased, but also the potential (signal level) of the ECL signals must be shifted towards a much lower potential (signal level) for the CMOS signals.

Furthermore, ECL and CMOS circuit parts are often allocated to different voltage supply systems, which may vary within given tolerances. However, the supply voltage of one system may be at the upper tolerance level and the supply voltage of the other system may be at the lower tolerance level, thus further increasing the difference between the operating voltages. Additionally, the variations of the supply voltages may vary independent from one another.

Typically, the ECL part has an operating (supply) voltage of 3.3 V ± 0.3 V and the CMOS part has an operating (supply) voltage of 1.8 V ± 0.3 V. Hence, the converter must be able to deal with differences in supply voltage between the ECL and CMOS part of as much as 2.1 V.

### Object of the invention

It is the object of the invention to provide an ECL to CMOS converter for an ECL part with a first supply voltage and a CMOS part with a second supply voltage.

### Short description of the invention

This object is achieved by a converter for converting ECL input signals delivered from an ECL circuit part operating at a first supply voltage into CMOS output signals for a CMOS circuit part operating at a second, different operating voltage, comprising an input stage for decoupling and shifting the signal level, i.e. the potential of the ECL signals, a level shifter connected to the input stage, and an output stage having the CMOS signals at its output, wherein the input stage and the level shifter are connected to the ECL operating voltage and the output stage is connected to the CMOS operating voltage.

Such a converter works over a wide range of power supply voltages and tolerances of the operating voltages. For example, the operating voltage of the ECL part may be 3.3 V ± 0.3 V or 2.5 V ± 0.3 V and the CMOS operating voltage may be 1.8 V ± 0.3 V. Such a converter may be realized with few devices and therefore small circuit area. Furthermore, the number of active devices and their deviations (or size) may be kept low such that the level conversion may be performed extremely fast with propagation delays below 250 ps.

In a particularly preferred embodiment the level shifter comprises a differential stage containing p-type field effect transistors (PFETs) or pnp bipolar transistors. Such a PFET or pnp bipolar differential stage works over a wide range of power supply voltages for the ECL and CMOS part. The differential stage may be operated with a reference voltage, which corresponds approximately to half the CMOS supply voltage. The voltage available for the differential stage corresponds to the ECL operating voltage minus half the CMOS supply voltage. Since the ECL supply voltage is generally larger than the CMOS supply voltage, a much larger voltage is available to the differential stage above half the CMOS supply voltage than between half the CMOS supply voltage and ground.

It is particularly advantageous if a control circuit is provided for controlling the threshold voltage of the level shifter. Using a control circuit allows precise control of the CMOS threshold voltage which is used as input voltage for the level shifter, thus controlling the current in the differential stage. Hence, the threshold voltage of the differential stage may be directly controlled by the CMOS switching threshold voltage.

The control circuit may preferably comprise a CMOS inverter supplied with the CMOS operation voltage, two resistors for providing a mean voltage from the output signals of the level shifter, and an operational amplifier connected with the non-inverting input port and the output port to the level shifter and with the inverting input port to the CMOS inverter. Measurement of the output voltage of the level shifter allows precise control of the CMOS switching threshold voltage and results in independence from temperature or technology parameter variations. The measured mean voltage, which corresponds to the signal level of the output signals of the level shifter, around which the output signals of the level shifter swing, is compared to the CMOS threshold voltage by the operational amplifier, the output port of which is connected to the gate of a PFET, acting as current source for the differential stage, thus controlling the current in the differential stage. The CMOS threshold value is easily obtained by short-circuiting the CMOS inverter.

Advantageously, the input stage comprises at least one emitter follower. If two ECL signals are to be processed, in particular differential ECL signals, preferably two emitter followers are provided for decoupling the signals and reducing the potential of the ECL signals. The input stage may even comprise two emitter followers, if only one ECL signal is to be processed. In this case the second input port of the input stage should be supplied with a reference voltage.

In a preferred further development of the embodiment the emitter follower comprises at least one diode for reducing the ECL signal level. If a bipolar transistor with emitter and base being short-circuited is used as diode, the level of the ECL input signal may be reduced by two diode forward voltages , i.e. approximately 1.6 V. Thus, the gate voltages of the PFETs of the differential stage, which correspond to the reduced level ECL signals, are shifted into a range where variations of the operating voltages do not influence the differential amplification of the differential stage.

In a preferred embodiment the output stage comprises at least one CMOS inverter for pulse forming. The output stage receives signals, in case of differential ECL signals differential signals, form the level shifter. These signals are transformed into CMOS compatible output signals by the inverters in the output stage. Preferably, for each output signal two CMOS inverters connected in series are provided. The inverters in the output stage are supplied with the CMOS operating voltage and are formed by p-type and n-type field effect transistors, which are identical to those used in the CMOS inverter of the control circuit. Supplying the CMOS inverter of the control stage, the CMOS inverters of the output stage, and the subsequent CMOS circuit part with the same operating voltage has the advantage that reliable operation of the converter is ensured even if the temperature, operating voltage and technology parameters vary. This is because the threshold value of all the CMOS inverters is the same and may be used to control the threshold voltage of the level shifter.

The full benefit of the converter described above may be appreciated if the converter is included in an optical transceiver module, in particular a 10 Gbit/s optical transceiver module.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- **Fig. 1**: shows a circuit diagram of a converter for converting ECL signals to CMOS signals;
- **Fig. 2**: shows the signal conversion for an ECL operation voltage of 3.6 V and a CMOS operation voltage of 1.5 V;
- **Fig. 3**: shows the signal conversion for an ECL operation voltage of 3.0V and a CMOS operation voltage of 2.1V.

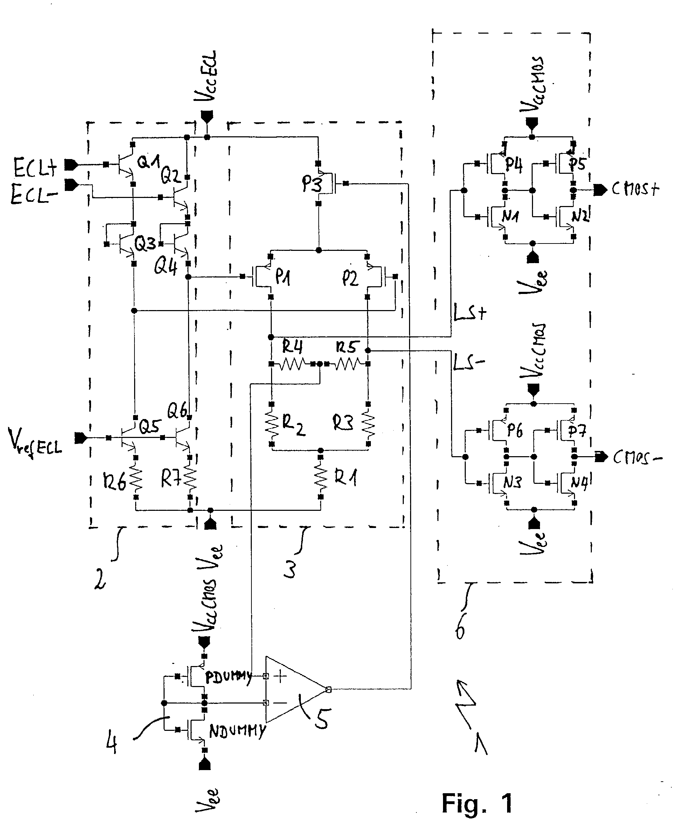

The circuit diagram of **Fig. 1** shows a converter **1** comprising an input stage **2** which is supplied with differential ECL signals **ECL+, ECL-** by an ECL stage not shown in Fig. 1. The input stage **2** comprises a first emitter follower for the signal ECL+, comprising the elements **Q1, Q3, Q5 and R6,** wherein Q5 and R6 form the current source of the first emitter follower. The input stage 2 further comprises a second emitter follower for the signal ECL-, comprising the elements **Q2, Q4, Q6 and R7**, wherein Q6 and R7 form the current source of the second emitter follower. The input stage decouples the input signals ECL+, ECL- and shifts their potential. The transistors Q3, Q4 having their respective base and emitter short-circuited act as diodes for lowering the potential of the ECL input signals ECL+, ECL- by two forward diode voltages, i.e. approximately 1.6V. The input stage 2 is connected to the operation voltage (supply voltage) VccECL of the ECL circuit part.

The converter 1 further comprises a level shifter **3** comprising the transistors **P1 - P3,** and resistors **R1 - R3,** wherein the transistors P1, P2 form a differential stage operating as a differential amplifier. The level shifter 3 is supplied with the ECL operation voltage VccECL. The output of the first emitter follower is connected to the gate of the p-type field effect transistor (PFET) P2 and the output of the second emitter follower is connected to the gate of the PFET P1. The lowering of the potential of the ECL signals ECL+ and ECL- results in the gate voltages of the PFETs P1, P2 being shifted into a region where variations in the operating voltage do not influence the differential amplification of the level shifter 3. The gate of the PFET P3 may be supplied with a constant reference voltage, but is preferably supplied by a control circuit comprising a CMOS inverter 4 connected to an operational amplifier 5, and two resistors R4, R5. The level shifter 3 is dimensioned such that for a given current through the level shifter, determined by the gate voltage of PFET P3, the level of the "High" state is determined by the voltage drop at R1 and R2 or R3. The differential stage is designed such that the transistors P1, P2 are nearly switched off (cut-off) or on for a defined ECL input signal. The distribution of the current between PFETs P1, P2 depends on the exact dimensioning, wherein switching velocity, amplification and transistor size must be optimized.

In the differential stage either P1 or P2 is conducting, depending on the gate potentials. If, for example, P1 is switched on, the current flows through R1, R2, P1 and P3, resulting in a voltage drop at R1 and R2. The drain potential LS+ of P1 is then at the logic level "low" and LS- is at the logic level "high". The logic levels adjusted by R1 and R2/R3 should be symmetrical to the threshold voltage of the CMOS inverters **P4,PN1; P6,N3** in the output stage **6** in order to achieve fast switching.

The threshold voltage of the CMOS inverter 4, comprising the p-type field effect transistor **PDUMMY** and the n-type field effect transistor **NDUMMY**, is used as reference input variable for the control. This reference input variable is directly compared by the operational amplifier 5 with the actual mean voltage of the signal level swing of the differential stage. Hence, the non-inverting input port of the operational amplifier is connected to the CMOS inverter 4 and the inverting input port is connected to the level shifter 3. The threshold voltage of the CMOS inverter 4 is generated by short circuiting the CMOS inverter 4. The identical resistors R4, R5 generate a mean voltage from the differential output signals LS+, LS- of the level shifter 3, which mean voltage is equal to the threshold voltage of the differential stage (P1, P2). The operational amplifier 5 pulls the mean voltage of the differential stage onto the threshold voltage of the CMOS inverter 4 by controlling the current through the PFET P3, which is connected to the output port of the operational amplifier 5. Thus, the signal levels of the output signals LS+, LS- of the level shifter 3 and hence of the differential stage (P1, P2) are always centered around the threshold voltage of the CMOS inverter 4, i.e. symmetrical to the threshold voltage. The CMOS inverter 4 is identical to the CMOS inverters P4, N1; **P5, N2;** P6, N3; **P7, N4** of the output stage 6.

The CMOS inverter 4 is supplied with the CMOS operating voltage **VccCMOS**, the same as the inverters P4, N1; P5, N2; P6, N3; P7, N4 of the output stage 6. The inverters P4, N1; P5, N2; P6, N3; P7, N4 in the output stage 6 serve for pulse forming and provide the CMOS compatible differential CMOS signals **CMOS+, CMOS-** for a CMOS part not shown in Fig. 1

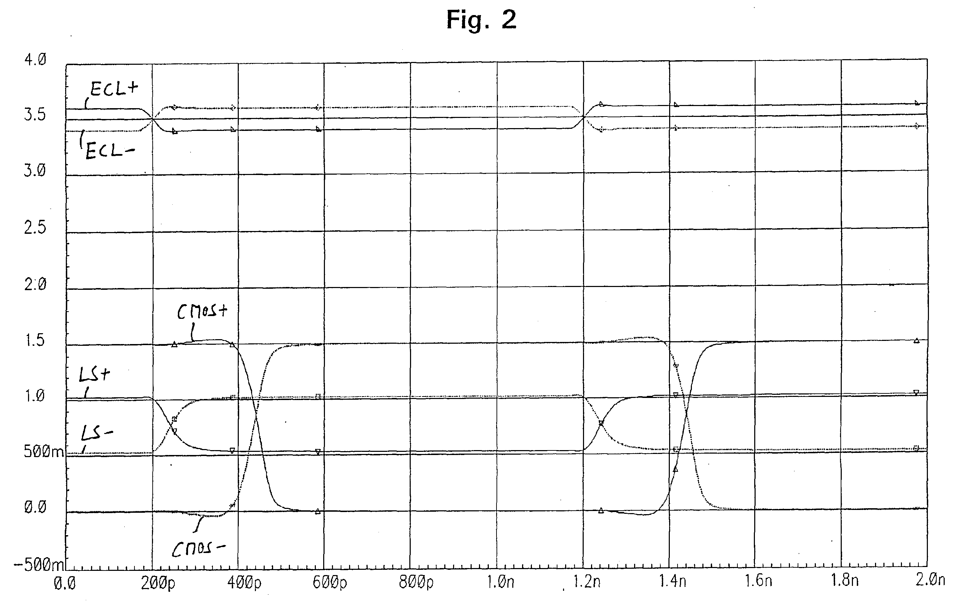

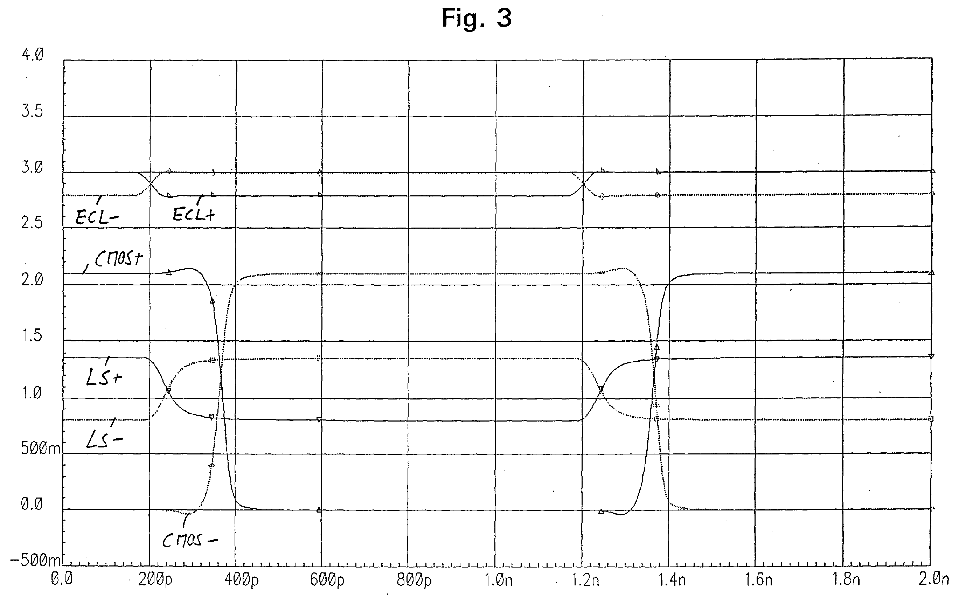

**Figs. 2 and 3** show the signals at the converter of Fig. 1 for a signal conversion from an ECL part with an operating voltage of VccECL = 3.3 V ± 0.3 V into a CMOS part having an operating voltage of VccCMOS = 1.8 V ± 0.3 V.

In Fig. 2 the ECL operating (or supply) voltage VccECL is at the maximum tolerance level i.e. 3.6 V and the CMOS operating voltage is at the minimum tolerance level, i.e. 1.5 V. It can be seen that the signals ECL+, ECL- have a signal level swing of only a few hundred mV with respect to VccECL and are at a much higher signal level than the signals LS+, LS- and CMOS+, CMOS-. The signal level of the signals ECL+, ECL- is shifted towards the CMOS threshold voltage, which may be seen by signals LS+, LS-. LS+ and LS- are not only shifted towards the CMOS threshold voltage, but their signal level swing is also increased. The signals LS+ and LS - respectively are then converted into the signals CMOS+, CMOS -. The propagation delay in this case is approximately 170 ps for conversion of the ECL+ signal into the CMOS+ signal and for conversion of the ECL- signal into the CMOS- signal.

Fig. 3 shows the signal levels for VccECL being at the minimum tolerance level i.e. 3.0 V and the CMOS operating voltage being at the maximum tolerance level, i.e. 2.1 V. This time, despite the ECL operating voltage being lower than in Fig. 2, the signal level of the signals LS+, LS- is higher because the CMOS threshold voltage is higher and the signals LS+, LS- are centered on the CMOS threshold voltage. The propagation delay in this case is approximately 240 ps for conversion of the ECL+ signal into the CMOS+ signal and for conversion of the ECL- signal into the CMOS- signal.

## Claims

1. Converter (1) for converting ECL input signals (ECL+, ECL-)delivered from an ECL circuit part operating at a first supply voltage (VccECL) into CMOS output signals (CMOS+, CMOS-) for a CMOS circuit part operating at a second, different operating voltage (VccCMOS), comprising an input stage (2) for decoupling and shifting the signal level of the ECL signals (ECL+, ECL-), a level shifter (3) connected to the input stage (2), and an output stage (6) having the CMOS signals (CMOS+, CMOS-) at its output, wherein the input stage (2) and the level shifter (3) are connected to the ECL operating voltage (VccECL) and the output stage (6) is connected to the CMOS operating voltage (VccCMOS).

2. Converter according to claim 1, **characterized in that** the level shifter (3) comprises a differential stage containing p-type field effect transistors (PFETs) (P1, P2, P3) or pnp bipolar transistors.

3. Converter according to claim 1, **characterized in that** a control circuit is provided for controlling the threshold voltage of the level shifter.

4. Converter according to claim 3, **characterized in that** the control circuit comprises a CMOS inverter (4) supplied with the CMOS operation voltage (VccCMOS), two resistors (R4, R5) for providing a mean voltage from the output signals (LS+, LS-) of the level shifter (3) , and an operational amplifier (5) connected with the non-inverting input port and the output port to the level shifter (3) and with the inverting input port to the CMOS inverter (4).

5. Converter according to claim 4, **characterized in that** the CMOS inverter (4) is short circuited.

6. Converter according to claim 1, **characterized in that** the input stage (2) comprises at least one emitter follower.

7. Converter according to claim 5, **characterized in that** the emitter follower comprises at least one diode (Q3, Q4) for reducing the ECL signal level.

8. Converter according to claim 1, **characterized in that** the output stage (6) comprises at least one CMOS inverter (P4, N1; P5, N2; P6, N3; P7, N4).

9. Optical transceiver module including at least one converter (1) according to claim 1.
